# EUROPÄISCHE PATENTSCHRIFT

(11) **EP 2 574 685 B1**
(45) Veröffentlichungstag und Bekanntmachung des Hinweises auf die Patenterteilung: **08.07.2020**
(21) Anmeldenummer: 12173141.8
(22) Anmeldetag: 22.06.2012
(51) Int. Cl.: C23C 28/04, C23C 16/26, F16J 9/26, C23C 14/58, C23C 14/06, C23C 24/06, C23C 26/00, C23C 28/00, C23C 30/00

(54) **Gleitelement mit DLC-Beschichtung**
Sliding element with DLC coating
Elément coulissant doté d'un revêtement DLC

(30) Priorität: 29.09.2011 DE 102011083714
(43) Veröffentlichungstag der Anmeldung: 03.04.2013
(73) Patentinhaber: Federal-Mogul Burscheid GmbH, 51399 Burscheid (DE)
(72) Erfinder: Kennedy, Dr. Marcus, 40479 Düsseldorf (DE); Zinnabold, Michael, 51399 Burscheid (DE)
(74) Vertreter: Hoffmann Eitle

(56) Entgegenhaltungen:
- EP-A1- 1 783 349
- CN-A- 101 665 941
- CN-A- 101 921 983
- JP-A- 2004 339 564
- JP-A- 2007 177 313
- JP-A- 2008 001 955
- US-A1- 2008 220 257
- US-A1- 2011 203 468

## Beschreibung

### TECHNISCHES GEBIET

Die vorliegende Erfindung betrifft einen Kolbenring, mit einer DLC-Beschichtung auf einem Substrat.

### STAND DER TECHNIK

Grundsätzlich besteht bei hoch belasteten Motoren für die darin verwendeten Kolbenringe die Notwendigkeit, möglichst verschleißbeständige Laufflächenbeschichtungen aufzuweisen, wofür häufig PVD-Beschichtungen auf Hartstoffbasis und DLC-Beschichtungen zum Einsatz kommen. PVD-Beschichtungen sind zwar verhältnismäßig widerstandsfähig gegenüber Verschleißerscheinungen, bieten jedoch nicht die erforderlichen niedrigen Reibungskoeffizienten, die zu heute angestrebten minimalen Reibungsverlusten im Motor und damit zum heute angestrebten minimalen Treibstoffverbrauch führen würden. Aus diesem Grund wird häufig der Einsatz einer DLC-Beschichtung bevorzugt.

DLC ist eine Abkürzung für "Diamond-Like-Carbon" und bezeichnet einen amorphen, diamantähnlichen Kohlenstoff, der sich durch besondere Eigenschaften, wie hohen Widerstand gegen abrasiven und adhäsiven Verschleiß, Schutz gegen Oberflächenzerrüttung, chemische Stabilität, gute Wärmeleitfähigkeit und mechanische Eigenschaften (Härte und E-Modul) auszeichnet. Hohe Härten erhält man insbesondere für DLC-Schichtsysteme mit einem hohen Anteil an sp³-hybridisieren Kohlenstoffatomen, deren Stoffmengenanteil mehr als 60 Prozent beträgt. Dieser Stoff wird auch als tetraedrisch gebundener amorpher Kohlenstoff (ta-C) bezeichnet. Daneben werden jedoch auch DLC-Schichten verwendet, die einen geringeren Anteil an sp³-hybridisierten Kohlenstoffatomen aufweisen und weniger hart sind als die ta-C Schichtsysteme, beispielsweise wasserstoffhaltige und/oder metallhaltige DLC Systeme.

Nachteilig an bekannten DLC-Beschichtungen mit hohen Härten für Kolbenringe ist, dass ihre Elastizität und Plastizität und damit ihre Möglichkeit, Scherkräfte aufzunehmen, im Vergleich mit verhältnismäßig weichen Schichten nur sehr gering ausgeprägt ist. Dies führt dazu, dass insbesondere im sogenannten Einlauf eines Motors schon kleinste Unebenheiten auf der Oberfläche des Gleitelements oder des Laufpartners zu einer Zerrüttung der Beschichtungsoberfläche und damit zu einem Versagen der DLC-Beschichtung schon bei geringen Flächenpressungen führen kann.

Eine weiche DLC-Schicht hat dagegen den Nachteil, einen zu geringen Verschleißwiderstand aufzuweisen, sodass bereits nach relativ kurzer Lebensdauer die DLC-Schicht verschlissen und der durch sie erzeugte, niedrige Reibungskoeffizient nicht mehr aufrechtzuerhalten ist.

Beispielhaft sei aus dem Stand der Technik die CN 101665941 A erwähnt, die eine Ti-dotierte diamantähnliche Dünnschicht auf oxidierten Oberflächen von Magnesiumlegierungen mit guten Abnutzungs- und Schmiereigenschaften beschreibt. Sowie ferner die JP 2004-339564, die Gleitelemente mit einer DLC-Schicht mit darauf aufgebrachter Festschmierstoffschicht, zum Beispiel MoS₂ oder NbS₂ zu Verbesserung der Reibeigenschaften beschreibt. Weiterer Stand der Technik ist in der Patentschrift US 2008/0220257 A1 offenbart.

### DARSTELLUNG DER ERFINDUNG

Somit liegt die Aufgabe der vorliegenden Erfindung darin, einen Kolbenring mit einer DLC-Beschichtung auf einem Substrat bereitzustellen, dass sowohl einen niedrigen Reibungskoeffizienten als auch eine hohe Verschleißbeständigkeit aufweist und dabei auch kleine Unebenheiten auf der Oberfläche eines Laufpartners tolerieren kann, ohne dabei wesentlich beschädigt zu werden.

Die Lösung der Aufgabe wird durch den Gegenstand des Anspruchs 1 und das Verfahren nach Anspruch 7 gegeben.

Weitere vorteilhafte Ausführungsformen der Erfindung ergeben sich aus den Unteransprüchen.

Erfindungsgemäß ist ein Kolbenring, mit einer DLC-Beschichtung auf einem Substrat dadurch gekennzeichnet, dass in die Oberfläche der DLC-Beschichtung, mit welcher der Kolbenring in Kontakt mit einem Gleitpartner kommen soll, ein weicheres Material als DLC eingebettet ist. Der Gleitpartner ist dabei ein Element, gegenüber dem der Kolbenring gleiten soll, beispielsweise eine zu dem betreffenden Kolben gehörige Zylinderwand.

Durch die Einbettung eines weicheren Materials in die Oberfläche der DLC-Beschichtung wird bewirkt, dass insbesondere das kritische Einlaufverfahren eines Kolbenrings zur Ausbildung eines sogenannten dritten Körpers schadlos überstanden werden kann. Unter einem sogenannten dritten Körper wird eine Schicht in der DLC-Beschichtung verstanden, die sich während des Einlaufens eines Kolbenrings gegenüber einer Zylinderwand ausbildet. Eigenschaften des dritten Körpers lassen sich beispielsweise der WO 2010/009 862 A1 entnehmen. Der Effekt der Ausbildung eines dritten Körpers ergibt sich auch bei anderen Gleitelementen als Kolbenringen.

In einer bevorzugten Ausführungsform weist das weichere Material ein Metall oder Metalloxid, insbesondere Eisen oder eine Eisen-Chrom-Verbindung oder deren Oxide, die weicher als die DLC-Beschichtung sind, auf. Diese Ausführungsform wird insbesondere dann bevorzugt, wenn die Zylinderlaufbahn, das heißt der Gleitpartner des Kolbenrings, eine Beschichtung aus einem entsprechenden Metall oder Metalloxid aufweist. Im Bereich der Verbrennungsmotoren werden zunehmend eisenbasierte thermisch beschichtete Bohrungen als Gleitpartner der Kolbenringe verwendet, die Eisen-Kohlenstoff- oder Eisen-Chrom-Legierungen oder dergleichen aufweisen. Durch den Prozess des thermischen Spritzens können bei entsprechend eingestellten Parametern auch Metalloxide in die Beschichtung eingebracht werden, um das Verschleißverhalten zu verbessern. Eine Ausbildung des Kolbenrings im Sinne dieser bevorzugten Ausführungsform führt dann dazu, dass ein während des Einlaufprozesses stattfindender Materialtransfer zwischen der DLC-Beschichtung des Kolbenrings und dem Gleitpartner bereits vorweggenommen ist und der Einlaufprozess daher schad- und gefahrlos durchgeführt werden kann.

Mit Vorteil weist die DLC-Beschichtung tetraedrisch gebundenen amorphen Kohlenstoff (ta-C) auf, da dieser sich durch besondere Härte und damit Verschleißbeständigkeit auszeichnet.

In einer weiter bevorzugten Ausführungsform weist die Oberfläche der DLC-Beschichtung das weichere Material zu 15 bis 60 Prozent, bevorzugt zu 20 bis 40 Prozent, seiner Fläche auf. Diese flächenmäßige Konzentration des weicheren Materials, insbesondere also des Metalls oder Metalloxids, erzielt bestmögliche Verschleiß- und Reibungswerte. In außermotorischen und motorischen Untersuchungen wurde festgestellt, dass ein zu hoher Anteil des weicheren Materials das Risiko von Mikroverschweißungen und damit von Fressen sowie die Gefahr von Ausbrüchen aus der DLC-Beschichtung durch einen zu schnellen Verschleiß des weicheren Material erhöht, was zu einer Erhöhung des Verschleißes bis hin zu einer Zerrüttung der Schicht führen kann. Eine zu niedrige Konzentration des weicheren Materials in der Oberfläche der DLC-Beschichtung führt dagegen dazu, dass der erwünschte Effekt der Erhöhung der Elastizität und Plastizität der DLC-Beschichtung und damit die Erhöhung der Aufnahmefähigkeit von Scherkräften nur unzureichend ist, da dann ein optimalen Einlauf zur Sicherstellung der Lebensdauer der Beschichtung nicht mehr gewährleistet ist. Der beschriebene Flächenanteil hat sich als besonders vorteilhaft in beiderlei Hinsicht erwiesen.

Bevorzugt erstreckt sich der Bereich der DLC-Beschichtung, in dem das weichere Material eingebettet ist, von der Oberfläche bis zu einer Tiefe von 1 *µ*m, bevorzugt bis zu einer Tiefe von 0,5 *µ*m, in die DLC-Beschichtung hinein. Diese Einbettungstiefe des weicheren Materials in die DLC-Beschichtung führt zu einem optimalen Einlaufverhalten eines DLC beschichteten Kolbenrings, da hierdurch sowohl die niedrige Verschleißrate als auch der niedrige Reibungskoeffizient der DLC-Beschichtung weitestgehend aufrechterhalten werden können.

Weiter bevorzugt weist die Oberfläche eine möglichst geringe Rauheit auf, die durch eine gemittelte Rautiefe R_{z} von weniger als 2 *µ*m, bevorzugt von weniger als 1 *µ*m, und/oder eine reduzierte Spitzenhöhe R_{PK} von weniger als 0,15 *µ*m, bevorzugt von weniger als 0,1 *µ*m, definiert werden kann. Auf diese Weise wird erreicht, dass die Anzahl hoher punktuell auftretender Flächenpressungen möglichst klein gehalten wird, was zu besonders guten Gleiteigenschaften führt.

In einer bevorzugten Ausführungsform beträgt die Härte der DLC-Beschichtung außerhalb der Bereiche mit dem weicheren Material 10 bis 70 GPa, bevorzugt 15 bis 50 GPa. Diese Härte ermöglicht einen geringen Verschleiß der DLC-Beschichtung und steht dem Effekt der Elastizitätserhöhung und damit erhöhten Toleranz gegenüber durch Oberflächenfehler entstehenden Scherkräften nicht im Wege. Bevorzugt enthält die DLC-Beschichtung Wasserstoff und entspricht dem Typ a-C:H, a-C:H:Me, ta-C:H oder a-C:H:X. Me ist dabei ein bevorzugt aus Chrom, Wolfram und Titan ausgewähltes Metall und X ein bevorzugt aus Silizium, Sauerstoff, Stickstoff und Bor ausgewähltes Nichtmetall.

Alternativ bevorzugt entspricht die DLC-Beschichtung dem Typ ta-C oder a-C und ist wasserstofffrei.

Die beiden genannten bevorzugten Varianten des Kolbenrings ermöglichen eine große Härte und damit Verschleißbeständigkeit und gleichzeitig einen niedrigen Reibungskoeffizienten.

In einer bevorzugten Ausführungsform weist der Kolbenring zwischen dem Substrat und der DLC-Beschichtung eine bevorzugt metallhaltige Haftschicht auf, die insbesondere eine Dicke von 0,1 *µ*m bis 1,0 *µ*m hat. Eine solche Haftschicht verbessert die Haftung der DLC-Beschichtung auf dem Substrat und dient damit zusätzlich der Langlebigkeit des Kolbenrings.

Bevorzugt ist das Substrat dabei Gusseisen oder Stahl, da diese Materialien sich für den Einsatz als Kolbenring oder vergleichbares Gleitelement aufgrund ihrer Festigkeit und gleichzeitigen Elastizität besonders eignen.

Ein erfindungsgemäßes Verfahren zur Herstellung eines Kolbenrings, wie es oben beschrieben wurde, ist dadurch gekennzeichnet, dass in einer Oberfläche einer DLC-Beschichtung des Kolbenrings, die in Kontakt mit einem Gleitpartner kommen soll, ein weicheres Material als DLC eingebracht wird. Das weichere Material, bevorzugt ein Metall- oder Metalloxid, insbesondere Eisen oder eine Eisen-Chrom-Verbindung oder deren Oxide, wird also in die DLC-Beschichtung eingebracht, nachdem diese bereits auf das Substrat aufgebracht wurde.

Das Einbringen des weicheren Materials in die Oberfläche der DLC-Beschichtung kann dabei bevorzugt durch Beschichten oder durch Einarbeiten vorgenommen werden. Mögliche Verfahren des Einarbeitens sind ein mechanisches Bürsten mit einer Stahlbürste, ein Stahlbandpolierprozess oder Läppen. Das Beschichten des Substrats kann beispielsweise durch Strahlen, Sputtern oder PVD-Arc Prozesse erfolgen.

Ein unabhängiger Aspekt der vorliegenden Erfindung liegt in der Verwendung eines der vorgenannten Verfahren, um einen Kolbenring mit einem Material zu versehen, das in einer Zylinderwand eines Verbrennungsmotors vorliegt, gegenüber welcher der Kolbenring bei seinem bestimmungsgemäßen Einsatz gleitet. Diese Verwendung ist davon abzugrenzen, lediglich ein Bearbeitungsverfahren einer Oberfläche einer DLC-Beschichtung vorzunehmen, da erfindungsgemäß das Material, das in die Oberfläche der DLC-Schicht eingebracht wird, auf den zukünftigen Gleitpartner des Gleitelements, insbesondere also des Kolbenrings, abgestimmt ist.

Durch die vorstehend geschilderte Erfindung ist es möglich, die Reduzierung der Reibung zwischen einem Kolbenring und einer Zylinderwand, oder allgemein einem Gleitelement und einem Gleitpartner zu realisieren, die insbesondere bei Verbrennungsmotoren mit einem reduzierten Kraftstoffverbrauch einhergeht und daher durch große Anstrengungen angestrebt wird. Gleichzeitig ist der erfindungsgemäße Kolbenring verschleißresistent und tolerant gegenüber Unebenheiten auf der Oberfläche eins Gleitpartners, so dass beispielsweise während Einlaufens eines Verbrennungsmotors eine Zerrüttung der Oberfläche des Kolbenrings nicht zu befürchten ist.

Weitere Vorteile, Merkmale und vorteilhafte Ausgestaltungen der Erfindung ergeben sich aus der Gesamtheit der Patentansprüche und der nachfolgenden Figurenbeschreibung.

### KURZE FIGURENBESCHREIBUNG

- Fig. 1: zeigt eine SEM-Photographie einer bevorzugten DLC beschichteten Oberfläche.
- Fig. 2: zeigt ein Elementtiefenprofil einer DLC-Beschichtung mit eingelagerten Metallen und Metalloxiden.
- Fig. 3: zeigt einen Vergleich der Verschleißwerte zweier DLC-Beschichtungen.
- Fig. 4: zeigt ein Diagramm eines Kraft- und Reibungsverlaufes von DLC beschichteten Kolbenringen mit und ohne Metalleinlagerungen.

### WEGE ZUR AUSFÜHRUNG DER ERFINDUNG

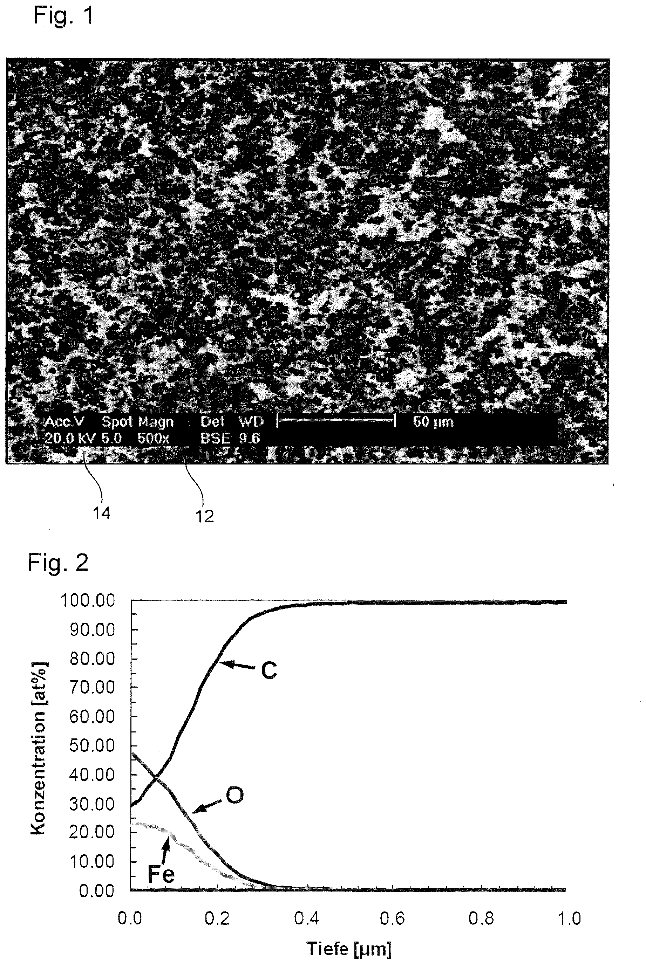

Fig. 1 zeigte eine SEM-Aufnahme der Oberfläche einer DLC-Beschichtung 12 mit Metall-/Metalloxideinlagerungen 14 bei einer Ausgangsschichtdicke von 12 *µ*m. Der Flächenanteil der Metall-/Metalloxideinlagerungen 14 beträgt hierbei 39 Prozent. Es wurden Versuche unternommen, bei denen verschiedene Proben mit Metall-/Metalloxideinlagerungen versehen wurden, deren Flächenanteile zwischen 27,8 Prozent und 39 Prozent lagen.

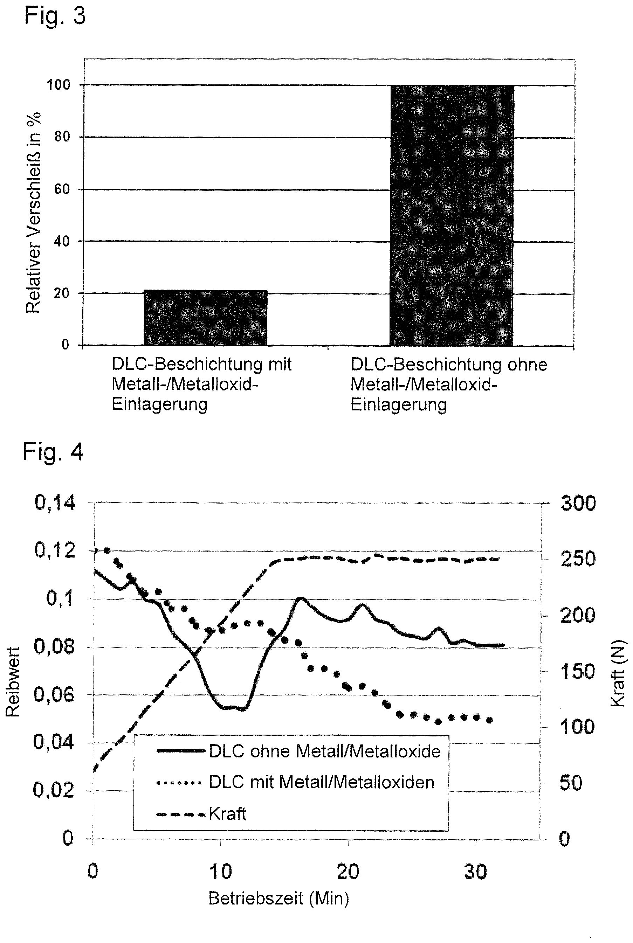

Die mit Metall-/Metalloxideinlagerungen versehenen Proben wiesen bei Reibungs- und Verschleißtests wesentlich bessere Eigenschaften auf als unbehandelte DLC-Beschichtungen. Dies ergibt sich auch aus den Figuren 3 und 4, die weiter unten kurz erläutert werden.

Fig. 2 zeigt die Tiefenprofile der Hauptbestandteile einer DLC-Beschichtung, in deren Oberfläche Eisen und Eisenoxid eingebracht wurde. Auf der Hochachse ist jeweils der Stoffmengenanteil der drei Hauptbestandteile Kohlenstoff (C), Sauerstoff (O) und Eisen (Fe) aufgetragen, die Rechtsachse beschreibt die Schichttiefe von der Oberfläche der DLC-Schicht aus bis zu einer Tiefe von 1 *µ*m.

Wie diesem Diagramm zu entnehmen ist, reichen die messbaren eingebetteten Anteile des Eisen und Eisenoxids nur bis 0,5 *µ*m. Darunter ist die DLC-Beschichtung ohne entsprechende Einbettung von Eisen oder Eisenoxid ausgeführt.

Es wurde anhand von motorischen Untersuchungen festgestellt, dass die Einbettung des Metall-/Metalloxids bis zu einer Tiefe von 0,5 *µ*m besonders wirksam ist. Dagegen konnte der Metallanteil in der DLC-Beschichtung nach einem Motortest über 240 Stunden bei einem Ringverschleiß von 0,7 bis 1,0 *µ*m nicht mehr detektiert werden.

Fig. 3 zeigt den relativen Verschleiß einer DLC-Beschichtung ohne Metall-/Metalloxideinlagerungen bzw. mit solchen Einlagerungen. Auf der linken Seite des Diagramms von Fig. 3 ist die DLC-Beschichtung mit Einlagerungen dargestellt. Das Diagramm zeigt, dass der Verschleiß der DLC-Beschichtung mit Metall-/Metalloxideinlagerungen nur etwa 20 Prozent des Verschleißes einer DLC-Beschichtung ohne Einlagerungen beträgt.

Der Verschleiß wurde dabei im sogenannten Schwing-Reibverschleißtest gemessen, bei dem der Kolbenring mit einer konstanten Last und einer konstanten Geschwindigkeit auf einem Gegenkörper im geschmierten Zustand schwingt.

Fig. 4 zeigt schließlich ein weiteres Diagramm, in dem der Kraft- und der Reibungsverlauf von DLC beschichteten Kolbenringen mit und ohne Metall-/Metalloxideinlagerungen gegen die Zeit aufgetragen ist.

Dabei stellt die durchgezogene Kurve den Reibungsverlauf einer DLC-Beschichtung ohne Metall-/Metalloxideinlagerungen, die gepunktete Kurve den Reibungsverlauf einer DLC-Beschichtung mit Metall-/Metalloxideinlagerungen und die gestrichelte Kurve einen Kraftverlauf zeitlich dar.

Aus der Fig. 4 ist zu erkennen, dass die DLC-Beschichtung mit Metall-/Metalloxideinlagerungen einen niedrigeren Verschleiß hat als diejenige ohne solche Einlagerungen in der Oberfläche, weil die Reibung der DLC-Beschichtung ohne Einlagerungen nach einer kurzen Einlaufphase von 10-12min zunimmt, während die Reibung der DLC-Beschichtung mit Einlagerungen nahezu stetig abnimmt.

## Patentansprüche

1. Kolbenring mit einer DLC-Beschichtung (12) auf einem Substrat, **dadurch gekennzeichnet, dass** in die Oberfläche der DLC-Beschichtung (12), mit der der Kolbenring in Kontakt mit einem Gleitpartner kommen soll, gegenüber dem der Kolbenring gleiten soll, ein weicheres Material (14) als DLC eingebettet ist.

2. Kolbenring nach Anspruch 1, wobei das weichere Material (14) ein Metall oder Metalloxid, insbesondere Eisen oder eine Eisen-Chrom-Verbindung oder deren Oxide, die weicher als die DLC-Beschichtung (12) sind, aufweist.

3. Kolbenring nach einem der vorhergehenden Ansprüche, wobei die Oberfläche der DLC-Beschichtung (12) das weichere Material (14) zu 15-60%, bevorzugt zu 20-40%, seiner Fläche aufweist.

4. Kolbenring nach einem der vorhergehenden Ansprüche, wobei sich der Bereich der DLC-Beschichtung (12), in den das weichere Material (14) eingebettet ist, von der Oberfläche bis zu einer Tiefe von 1 *µ*m, bevorzugt bis zu einer Tiefe von 0,5 *µ*m, in die DLC-Beschichtung (12) hinein erstreckt.

5. Kolbenring nach einem der vorhergehenden Ansprüche, wobei die Oberfläche eine gemittelte Rautiefe R_{z} von weniger als 2 *µ*m, bevorzugt von weniger als 1 *µ*m, und/oder eine reduzierte Spitzenhöhe Rₚₖ von weniger als 0,15 *µ*m, bevorzugt von weniger als 0,1 *µ*m, aufweist.

6. Kolbenring nach einem der vorhergehenden Ansprüche, der ferner eine Haftschicht aus einem Metall, bevorzugt aus Chrom, Titan oder Wolfram, zwischen dem Substrat und der DLC-Beschichtung aufweist.

7. Verfahren zur Herstellung eines Kolbenrings nach einem der Ansprüche 1-6, wobei
in eine Oberfläche einer DLC-Beschichtung des Kolbenrings, die in Kontakt mit einem Gleitpartner kommen soll, gegenüber dem der Kolbenring gleiten soll, ein weicheres Material als DLC eingebracht wird.

8. Verfahren nach Anspruch 7, wobei als das weichere Material ein Metall oder ein Metalloxid, insbesondere Eisen oder eine Eisen-Chrom-Verbindung oder deren Oxide, die weicher als die DLC-Beschichtung sind, in die Oberfläche der DLC-Beschichtung eingebracht wird.

9. Verfahren nach Anspruch 8, wobei das weichere Material durch Beschichten oder durch Einarbeiten in die Oberfläche der DLC-Beschichtung eingebracht wird.

## Claims

1. Piston ring with a DLC coating (12) on a substrate, **characterised in that** a softer material (14) than DLC is embedded in the surface of the DLC coating (12) with which the piston ring is to come into contact with a sliding partner against which the piston ring is to slide.

2. Piston ring according to claim 1, wherein the softer material (14) comprises a metal or metal oxide, in particular iron or an iron-chromium compound or oxides thereof which are softer than the DLC coating (12).

3. Piston ring according to one of the preceding claims, wherein the surface of the DLC coating (12) comprises the softer material (14) over 15-60%, preferably 20-40%, of its surface area.

4. Piston ring according to one of the preceding claims, wherein the region of the DLC coating (12) in which the softer material (14) is embedded in the DLC coating (12) extends from the surface to a depth of 1 µm, preferably to a depth of 0.5 µm.

5. Piston ring according to one of the preceding claims, wherein the surface has a mean roughness depth Rz of less than 2 µm, preferably of less than 1 µm, and/or a reduced peak height Rpk of less than 0.15 µm, preferably of less than 0.1 µm.

6. Piston ring according to one of the preceding claims which further comprises an adhesive layer consisting of a metal, preferably chromium, titanium or tungsten, between the substrate und the DLC coating.

7. Method for producing a piston ring according to one of the claims 1-6, wherein
a softer material than DLC is introduced into a surface of a DLC coating of the piston ring which is to come into contact with a sliding partner against which the piston ring is to slide.

8. Method according to claim 7, wherein a metal or a metal oxide, in particular iron or an iron-chromium compound or oxides thereof which are softer than the DLC coating, is introduced into the surface of the DLC coating as the softer material.

9. Method according to claim 8, wherein the softer material is introduced into the surface of the DLC coating through coating or incorporation.

## Revendications

1. Segment de piston avec un revêtement DLC (12) sur un substrat, **caractérisé en ce qu'**un matériau plus mou (14) que le DLC est incorporé dans la surface du revêtement DLC (12) avec lequel le segment de piston doit entrer en contact avec un partenaire coulissant par rapport auquel le segment de piston doit coulisser.

2. Segment de piston selon la revendication 1, dans lequel le matériau plus mou (14) présente un métal ou un oxyde métallique, en particulier du fer ou un composé fer-chrome ou leurs oxydes, qui sont plus mous que le revêtement DLC (12).

3. Segment de piston selon l'une quelconque des revendications précédentes, dans lequel la surface du revêtement DLC (12) présente le matériau plus mou (14) sur 15 à 60 %, de préférence sur 20 à 40 %, de sa surface.

4. Segment de piston selon l'une quelconque des revendications précédentes, dans lequel la zone du revêtement DLC (12) dans laquelle le matériau plus mou (14) est incorporé s'étend de la surface jusqu'à une profondeur de 1 µm, de préférence jusqu'à une profondeur de 0,5 µm, dans le revêtement DLC (12).

5. Segment de piston selon l'une quelconque des revendications précédentes, dans lequel la surface présente une rugosité de surface moyenne R_{z} inférieure à 2 µm, de préférence inférieure à 1 µm, et/ou une hauteur de pic réduite Rₚₖ inférieure à 0,15 µm, de préférence inférieure à 0,1 µm.

6. Segment de piston selon l'une quelconque des revendications précédentes, qui présente en outre une couche adhésive d'un métal, de préférence du chrome, du titane ou du tungstène, entre le substrat et le revêtement DLC.

7. Procédé de fabrication d'un segment de piston selon l'une quelconque des revendications 1 à 6, dans lequel
un matériau plus mou que le DLC est introduit dans une surface d'un revêtement DLC du segment de piston qui doit entrer en contact avec un partenaire coulissant contre lequel le segment de piston doit coulisser.

8. Procédé selon la revendication 7, dans lequel en tant que matériau plus mou, un métal ou un oxyde métallique, en particulier du fer ou un composé fer-chrome ou leurs oxydes, qui sont plus mous que le revêtement DLC, est introduit dans la surface du revêtement DLC.

9. Procédé selon la revendication 8, dans lequel le matériau plus mou est introduit dans la surface du revêtement DLC par revêtement ou par incorporation dans la surface du revêtement DLC.
